# EUROPEAN PATENT SPECIFICATION

(11) **EP 1 906 439 B1**
(45) Date of publication and mention of the grant of the patent: **25.02.2015**
(21) Application number: 07017735.7
(22) Date of filing: 11.09.2007
(51) Int. Cl.: H01L 21/3213, H01J 37/32

(54) **Etching method**
Ätzverfahren
Procédé de gravure

(30) Priority: 28.09.2006 JP 2006265148
(43) Date of publication of application: 02.04.2008
(73) Proprietor: Tokyo Electron Limited (TEL), Tokyo 107-8481 (JP)
(72) Inventor: Iijima, Etsuo, Amagasaki-shi Hyogo 660-0891 (JP); Horiguchi, Katsumi, Amagasaki-shi Hyogo 660-0891 (JP)
(74) Representative: Hoffmann Eitle

(56) References cited:
- US-A- 4 502 915
- US-A- 5 242 536
- US-A1- 2005 026 440

## Description

### BACKGROUND OF THE INVENTION

### Field of the Invention

The present invention relates to an etching method and a semiconductor device fabrication method, and more particularly, to an etching method for etching a polysilicon layer formed on a gate oxide film and a semiconductor device fabrication method in which the etching method is implemented.

### Description of the Related Art

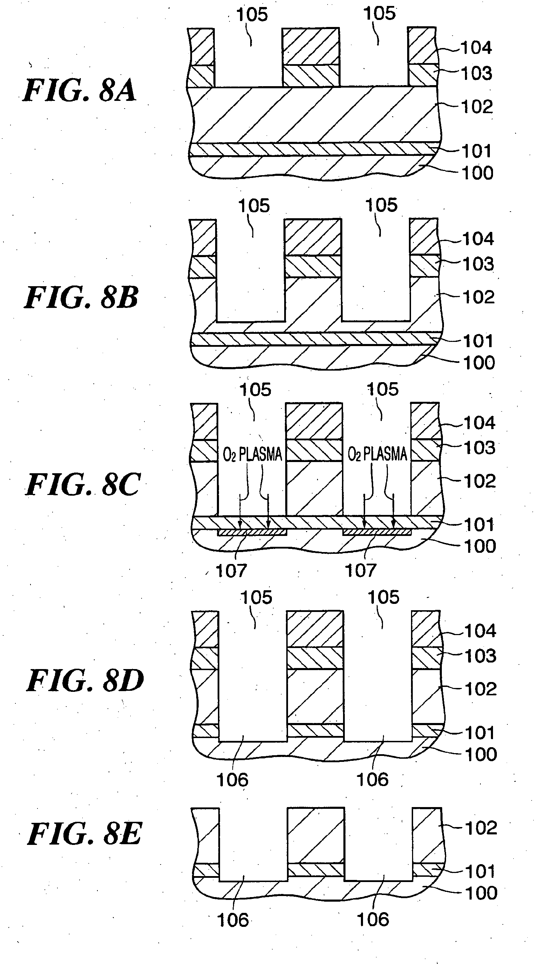

For formation of a semiconductor device gate of a single layer of polysilicon (polycrystal silicon), a wafer is processed that has a silicon base layer 100 on which are formed in layers a gate oxide film 101 of silicon oxide, a polysilicon film 102, an anti-reflection film (a BARC film) 103, and a resist film 104 (see, FIG. 8A). In this wafer, the anti-reflection film 103 and the resist film 104 are formed in predetermined patterns and an opening 105 through which the polysilicon film 102 is exposed is formed at a predetermined location on the wafer.

A wafer processing process includes a main etching step and an over-etching step that are implemented in a given chamber as a substrate processing chamber, and includes an oxide film etching step and an ashing step implemented in another chamber as a substrate processing chamber. The main etching step implemented in the given chamber etches the polysilicon film 102 to an extent that the film 102 slightly remains on the gate oxide film 101 (FIG. 8B). The over-etching step implemented in that chamber etches and fully removes the unetched polysilicon film 102 that remains on the gate oxide film, so that the gate oxide film 101 is exposed (FIG. 8C), whereupon the wafer is transferred into another chamber. The oxide film etching step implemented in the other chamber etches and removes the gate oxide film 101 so that the silicon base layer 100 is exposed (FIG. 8D) . The ashing step implemented in that chamber etches and removes the resist film 104 and the anti-reflection film 103 (FIG. 8E). It should be noted that the exposed silicon base layer 100 is subsequently doped with ions.

Usually, plasma employed for etching the polysilicon film 102 is generated from hydrogen bromide-based (HBr-based) processing gas that does not contain chlorine-based gas nor fluorine-based gas (see, Japanese Laid-open Patent Publication No. 10-172959, for example). Oxygen free plasma etching processes for polysilicon are disclosed in Document US-A-5 242 536 (LSI LOGIC CORPORATION [US]) 7 September 1993 (1993-09-07).

By the way, the use of processing gas mixed with oxygen gas makes it possible to increase the etching selectivity of the polysilicon film 102 to the gate oxide film 101, to thereby suppress the gate oxide film 101 from being etched. To this end, a processing gas mixed with oxygen gas is usually used in the over-etching step to prevent the gate oxide film 101 from being etched.

Since the gate oxide film 101 is thin in thickness, however, oxygen plasma generated from oxygen gas can pass through the gate oxide film 101 to reach the silicon base layer 100 in the over-etching step implemented in a given chamber (FIG. 8C). The oxygen plasma reaching the silicon base layer 100 can alter a part 107 of the silicon base layer 100 into silicon oxide. In that case, in the oxide film etching step performed in another chamber, plasma generated from HF-based gas removes not only the gate oxide film 101 but also the altered part 107 of the silicon base layer 100. As a result, recesses 106 are formed on a surface of the silicon base layer 100 at locations on both sides of the gate (FIG. 8D).

If recesses 106 are present on the silicon base layer 100, ions are not doped in a desired range at the time of ion implantation to the exposed silicon base layer 100. This makes it difficult or impossible for a semiconductor device to have a desired performance.

### SUMMARY OF THE INVENTION

The present invention provides etching method and semiconductor device fabrication method that are capable of increasing the selectivity of a polysilicon film to a silicon oxide film and preventing recesses from being formed on a silicon base layer.

The invention for which protection is sought is defined by claim 1. Embodiments relating to etching the part of the polysilicon film remaining on the silicon oxide film at an ambient pressure of 33.3 Pa to 93.3 Pa are not part of the claimed invention and are for illustrative purposes only. Further on, the hereafter described substrate processing apparatus is not part of the claimed invention.

According to a first aspect of the present disclosure, there is provided an etching method of a substrate having a silicon base layer on which at least a silicon oxide film, a polysilicon film, and a mask film having an opening are formed in sequence, comprising a first etching step of etching the polysilicon film using the mask film as a mask such that a part of the polysilicon film on a side remote from the opening remains on the silicon oxide film, and a second etching step of etching the part of the polysilicon film remaining on the silicon oxide film using plasma generated from a processing gas not containing oxygen gas, wherein in said second etching step, the part of the polysilicon film remaining on the silicon oxide film is etched at an ambient pressure of 33.3 Pa to 93.3 Pa.

With the etching method according to the first aspect, the polysilicon film is etched such that a part of the polysilicon film remains on the silicon oxide film, and then the part of the polysilicon film remaining on the silicon oxide film is etched at an ambient pressure of 33.3 Pa to 93.3 Pa using plasma generated from a processing gas not containing oxygen gas. At a pressure equal to or higher than 33.3 Pa, the sputter ability of plasma is lowered, and the etch rate of the oxide film is greatly lowered than that of the polysilicon film, which makes it possible to increase the selectivity of the polysilicon film to the silicon oxide film. Since oxygen gas is not used, the silicon base layer beneath the silicon oxide film is not oxidized, which makes it possible to suppress recesses from being formed on the silicon base layer.

In the second etching step, the part of the polysilicon film remaining on the silicon oxide film can be etched at an ambient pressure of 40.0 Pa to 80.0 Pa.

In this case, the unetched part of the polysilicon film is etched at an ambient pressure of 40.0 Pa to 80.0 Pa. At a pressure equal to or higher than 40.0 Pa, the sputter ability of plasma is extremely weakened, and an increased selectivity of the polysilicon film to the silicon oxide film can be ensured. As a result, occurrences of cracks on the silicon oxide film and the like can be prevented.

The processing gas not containing oxygen gas can be a mixture of hydrobromic gas and inactive gas.

In that case, the processing gas is a mixture of hydrobromic gas and inactive gas. Using plasma generated from the hydrobromic gas, the polysilicon film can be efficiently etched, to thereby improve throughput.

In the first etching step, the polysilicon film can be etched by using plasma generated from hydrobromic gas, fluorocarbon gas, or chlorine gas.

In that case, the polysilicon film is etched in the first etching step using plasma generated from hydrobromic gas, fluorocarbon gas, or chlorine gas. Plasma generated from the hydrobromic gas or the fluorocarbon gas or the chlorine gas can efficiently etch the polysilicon film, thereby further improve throughput.

The etching method can include a third etching step of etching the silicon oxide film.

In that case, the silicon oxide film is etched, whereby the silicon base layer to be doped with ions can reliably be exposed.

According to a second aspect of the present disclosure, there is provided a semiconductor device fabrication method for fabricating a semiconductor device from a substrate having a silicon base layer on which at least a silicon oxide film, a polysilicon film, and a mask film having an opening are formed in sequence, comprising a first etching step of etching the polysilicon film using the mask film as a mask such that a part of the polysilicon film on a side remote from the opening remains on the silicon oxide film, and a second etching step of etching the part of the polysilicon film remaining on the silicon oxide film using plasma generated from a processing gas not containing oxygen gas, wherein in said second etching step, the part of the polysilicon film remaining on the silicon oxide film is etched at an ambient pressure of 33.3 Pa to 93.3 Pa.

With the semiconductor device fabrication method according to the second aspect of this invention, the selectivity of the polysilicon film to the silicon oxide film can be increased and recess formation can be suppressed, as in the etching method according to the first aspect.

Further features of the present invention will become apparent from the following description of an exemplary embodiment with reference to the attached drawings.

### BRIEF DESCRIPTION OF THE DRAWINGS

FIG. 1 is a section view schematically showing the construction of a substrate processing apparatus for carrying out an etching method according to one embodiment of the present invention;

FIG. 2 is a plan view of a slot plate in FIG. 1;

FIG. 3 is a plan view, as seen from bottom, of a processing gas supply unit in FIG. 1;

FIG. 4 is a section view showing the construction of a wafer to be etched in the substrate processing apparatus in FIG. 1;

FIG. 5A to FIG. 5E are a process diagram of a etching method, as an etching method according to the embodiment, carried out to obtain a semiconductor device gate construction;

FIGS. 6A and 6B are section views showing the constructions of gates obtained by the etching, wherein FIG. 6A shows the construction of a gate obtained by etching a residual polysilicon film, _with a pressure in a processing space set at 66.7 Pa and HBr gas and He gas supplied to the processing space, and FIG. 6B shows the construction of a gate obtained by etching a residual polysilicon film, with a pressure in the processing space set at 13.3 Pa and HBr gas and oxygen gas supplied to the processing space;

FIGS. 7A and 7B are section views showing the constructions of gates in wafers obtained by etching a residual polysilicon film, with HBr gas and He gas supplied to the processing space, wherein FIG. 7A shows the construction of a gate obtained with a pressure of 13. 3 Pa in the processing space, and FIG. 7B shows the construction of a gate obtained with a pressure of 93.3 Pa in the processing space; and

FIG. 8A to FIG. 8E are a process diagram showing a conventional etching method for obtaining a gate construction.

### DETAILED DESCRIPTION OF THE PREFERRED EMBODIMENT

The present invention will now be described in detail below with reference to the drawings showing a preferred embodiment thereof.

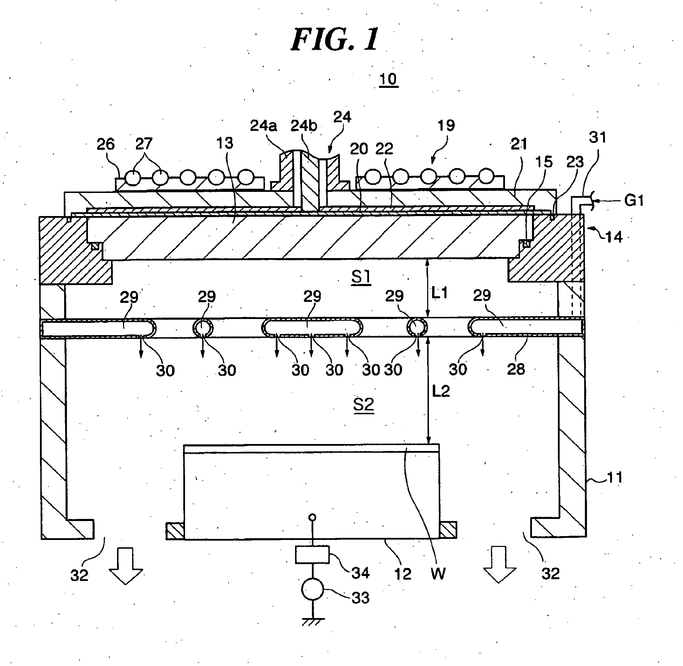

FIG. 1 is a section view schematically showing the construction of a substrate processing apparatus for carrying out an etching method according to one embodiment of the present invention.

Referring to FIG. 1, the substrate processing apparatus 10 includes a cylindrical processing vessel 11, and a susceptor 12 disposed in the processing vessel 11 and functioning as a cylindrical mounting stage adapted to be mounted with a wafer W, described later. The susceptor 12 includes an electrostatic chuck (not shown) adapted to attract and hold a wafer W through a Coulomb force or a Johnsen-Rahbek force.

The processing vessel 11 is formed, for example, of an austenite stainless steel containing A1, and has its inner wall surface covered by an insulating film (not shown) of alumite or yttria (Y₂O₃). A microwave-transmitting window 13 made of a dielectric plate such as a quartz plate is mounted through a ring member 14 to an upper part of the processing vessel 11 so as to face a wafer W attracted to and held on the susceptor 12. The microwave-transmitting window 13 is formed into a circular plate and permits a microwave, described later, to pass therethrough.

The microwave-transmitting window 13 has its outer edge portion formed with a stepped portion. The ring member 14 has an inner circumferential portion thereof formed with a stepped portion complementary to that of the microwave-transmitting window 13. The window 13 and the ring member 14 are joined to each other, with their stepped portions engaged with each other. A seal ring 15 formed by an O-ring is disposed between the stepped portion of the microwave-transmitting window 13 and that of the ring member 14. The seal ring 15 prevents leakage of gas from between the window 13 and the ring member 14, to thereby maintain gas-tightness of the processing vessel 11.

A radial line slot antenna 19, which is disposed on the microwave-transmitting window 13, is comprised of a circular plate-like slot plate 20 disposed in close contact with the microwave-transmitting window 13, a circular plate-like dielectric antenna plate 21 that holds and covers the slot plate 20, and a retardation plate 22 sandwiched between the slot plate 20 and the dielectric antenna plate 21. The retardation plate 22 is formed by a dielectric material of low loss such as Al₂O₃, SiO₂, or Si₃N₄.

The radial line slot antenna 19 is mounted via the ring member 14 to the processing vessel 11. A seal ring 23 formed by an O-ring seals between the radial line slot antenna 19 and the ring member 14. A coaxial waveguide 24, which is connected to the radial line slot antenna 19, is comprised of a waveguide pipe 24a and a rod-like central conductor 24 disposed coaxially with the waveguide pipe 24a. The waveguide pipe 24a is connected to the dielectric antenna plate 21, and the central conductor 24b is connected to the slot plate 20 through an opening, which is formed in the dielectric antenna plate 21.

The coaxial waveguide 24 is connected to an external microwave source (not shown) from which a microwave of 2.45 GHz or 8.3 GHz frequency is supplied via the coaxial waveguide 24 to the radial line slot antenna 19. The supplied microwave propagates in the radial direction between the dielectric antenna plate 21 and the slot plate 20. The retardation plate 22 compresses the wavelength of the propagating microwave.

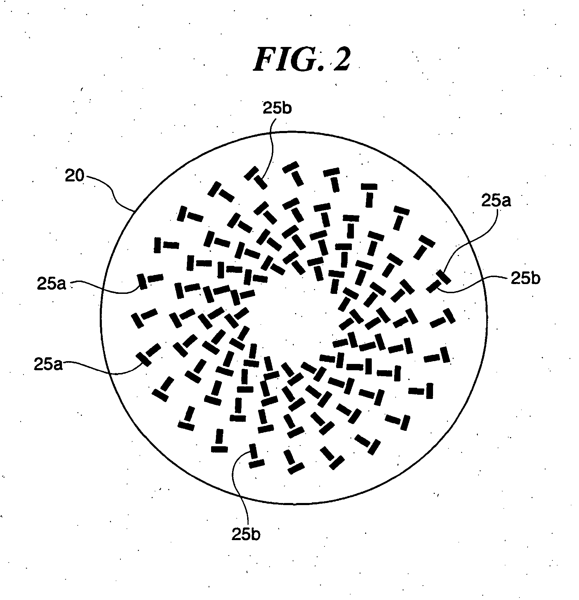

FIG. 2 is a plan view of the slot plate shown in FIG. 1.

Referring to FIG. 2, the slot plate 20 includes a plurality of slots 25a and a plurality of slots 25b the number of which is the same as that of the slots 25a. The slots 25a are disposed on a plurality of concentric circles. Each of the slots 25b is disposed to correspond to and to be perpendicular to a corresponding one of the slots 25a. In each slot pair comprised of a slot 25a and a corresponding slot 25b, the distance between the slots 25a, 25b as viewed in the radial direction of the slot plate 20 corresponds to the wavelength of the microwave compressed by the retardation plate 22. As a result, the microwave is radiated from the slot plate 20 in the form of near plane wave. Since the slots 25a, 25b are disposed in mutually perpendicular relation, the microwave radiated from the slot plate 20 forms a circular polarized wave that includes two perpendicular polarization components.

Referring to FIG. 1 again, the substrate processing apparatus 10 includes a coolant block 26 disposed on the dielectric antenna plate 21 and formed with coolant water passages 27. By heat exchange with coolant circulating in the coolant water passages 27, heat accumulated in the microwave-transmitting window 13 heated by the microwave is removed via the radial line slot antenna 19.

The substrate processing apparatus 10 further includes a processing gas supply unit 28 disposed between the microwave-transmitting window 13 and the susceptor 12 in the processing vessel 11. The processing gas supply unit 28 is formed by a conductor of, for example, a magnesium-containing aluminum base alloy or an aluminum-added stainless steel, and is disposed to face a wafer W on the susceptor 12.

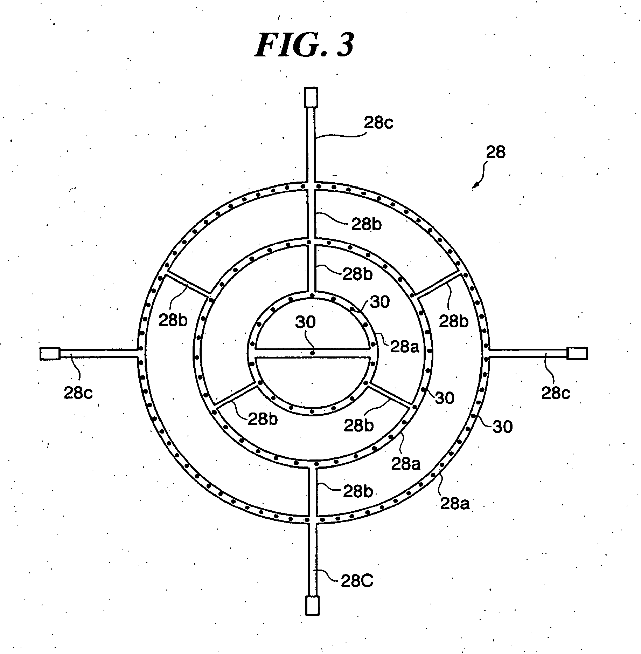

As shown in FIG. 3, the processing gas supply unit 28 includes a plurality of circular pipe sections 28a disposed on concentric circles having different diameters, a plurality of connection pipe sections 28b through which adjacent circular pipe sections 28a are connected to each other, and support pipe sections 28c that connect the outermost circular pipe section 28a to a side wall of the processing vessel 11 to thereby support the circular pipe sections 28a and the connection pipe sections 28b.

The circular pipe sections 28a, the connection pipe sections 28b, and the support pipe sections 28c are tubular in cross section, and processing gas diffusion passages 29 are formed in the interior of these pipe sections. The processing gas diffusion passages 29 are communicated, via a plurality of gas holes 30 formed in lower surfaces of the circular pipe sections 28a, with a processing space S2 defined between the processing gas supply unit 28 and the susceptor 12. The processing gas diffusion passages 29 are connected via a processing gas introduction pipe 31 with an external processing gas supply apparatus (not shown). A processing gas G1 is introduced into the passages 29 through the processing gas introduction pipe 31. The processing gas G1 introduced into the passages 29 is supplied through the gas holes 30 to the processing space S2.

It should be noted that it is not inevitably necessary for the substrate processing apparatus 10 to have the process gas supply unit 28. In that case, the ring member 14 may be formed with gas holes through which the processing gas is supplied to the processing spaces S1, S2.

The substrate processing apparatus 10 is further provided with a discharge port 32 that opens to a lower part of the processing vessel 11. The discharge port 32 is connected through an APC (automatic pressure control) value to a TMP (turbo molecular pump) and a DP (dry pup), none of which is shown. The TMP and the DP are adapted to discharge the gas in the processing vessel 11, to thereby control the pressure in the processing spaces S1, S2.

In the substrate processing apparatus 10, a high-frequency power supply 33 is connected to the susceptor 12 via a matcher 34 and supplies high frequency power to the susceptor 12, so that the susceptor 12 functions as a high frequency electrode. The matcher 34 reduces reflection of high frequency power from the susceptor 12 to thereby maximize the efficiency of supply of the high frequency power to the susceptor 12. The high frequency current from the power supply 33 is supplied via the susceptor 12 to the processing spaces S1, S2.

It should be noted that a distance L1 between the microwave-transmitting window 13 and the processing gas supply unit 28 (i.e., the thickness of the processing space S1) is 35 mm, whereas a distance L2 between the processing gas supply unit 28 and the susceptor 12 (i.e., the thickness of the processing space S2) is 100 mm. The processing gas G1 supplied from the processing gas supply unit 28 is a single gas or a mixture of gases selected from a group consisting of hydrogen bromide (HBr) gas, fluorocarbon (CF system) gas, chlorine (Cl₂) gas, hydrogen fluoride (HF) gas, oxygen (O₂) gas, hydrogen (H₂) gas, nitrogen (N₂) gas, and rare gas, for example, argon (Ar) gas or helium (He) gas.

In the substrate processing apparatus 10, the pressure in the processing spaces S1, S2 is controlled to a desired pressure, and the processing gas G1 is supplied from the processing gas supply unit 28 to the processing space S2. Then, high-frequency current is supplied via the susceptor 12 to the processing spaces S1, S2, and microwave is radiated from the slot plate 20 of the radial line slot antenna 19. The radiated microwave is radiated via the microwave-transmitting window 13 to the processing spaces S1, S2, whereby microwave electric field is formed. The processing gas G1 supplied to the processing space S2 is excited in the microwave electric field, whereby plasma is generated. At that time, the processing gas G1 is excited by the high-frequency microwave, making it possible to attain a high-density plasma. Using the plasma of the processing gas G1, a wafer W on the susceptor 12 is etched.

In the radial line slot antenna 19, the microwave supplied from the external microwave source is uniformly diffused between the dielectric antenna plate 21 and the slot plate 20. Accordingly, the microwave is uniformly radiated from a surface of the slot plate 20. As a result, a uniform microwave electric field is formed in the processing space S2, so that the plasma is uniformly distributed in the processing space S2, making it possible to uniformly etch a surface of the wafer W and hence ensure the uniformity of etching.

In the substrate processing apparatus 10, the processing gas G1 is excited for plasma generation in the vicinity of the processing gas supply unit 28 disposed apart from the susceptor 12. Since the plasma is generated only in a space located apart from the wafer W, the wafer W is prevented from being exposed to the plasma and the plasma reaching the wafer W has a decreased electron temperature. As a consequence, the semiconductor device structure on the wafer W is prevented from being destroyed. Furthermore, the processing gas G1 is prevented from being redissociated in the vicinity of the wafer W, and therefore, the wafer W is not contaminated (see, for example, online article dated June 9, 2003 on the web page of New Energy and Industrial Technology Development Organization, "Yamanaka and Atohda won the Prime Minister's Prize in the industry-academic-government award for their development of large-diameter, high-density plasma processing apparatus", searched on May 22, 2006 (URL: http://www.nedo.go.jp/informations/press/150609_1/15060 9_1.html).

In the above described substrate processing apparatus 10, a high-frequency microwave is employed for excitation of the processing gas G1, thereby capable of efficiently conveying energy to the processing gas G1. As a result, the processing gas G1 becomes liable to be excited, so that a plasma may be generated even under a high pressure circumstance. Thus, the wafer W can be etched without extremely lowering the pressure in the processing spaces S1, S2.

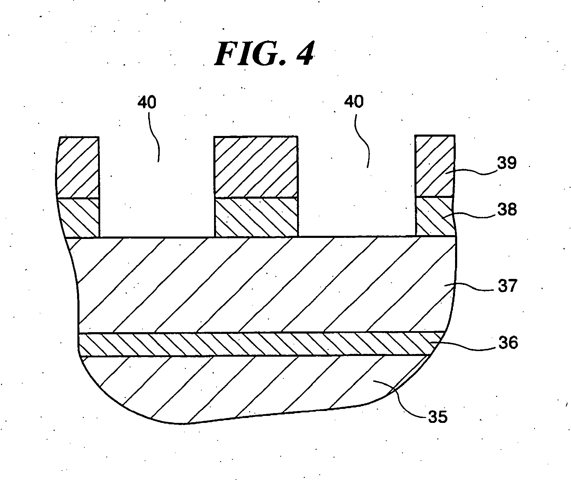

FIG. 4 is a section view showing the construction of a wafer to be etched in the substrate processing apparatus shown in FIG. 1.

Referring to FIG. 4, a semiconductor device wafer W is comprised of a silicon base layer 35 made of silicon, a gate oxide film 36 having a 1.5 nm film thickness formed on the silicon base layer 35, a polysilicon film 37 having a film thickness of 150 nm formed on the gate oxide film 36, an anti-reflection film 38 formed on the polysilicon film 37, and a resist film 39 (mask film) formed on the anti-reflection film 38. The anti-reflection film 38 and the resist film 39 of the wafer W are formed in predetermined patterns, and an opening 40 through which the polysilicon film 37 is exposed is formed at a predetermined position on the wafer W.

The silicon base layer 35 is formed by a circular thin plate of silicon, and the gate oxide film 36 is formed on a surface of the silicon base layer 35 by thermal oxidation processing. The gate oxide film 36 is formed of silicon oxide (SiO₂) and functions as an insulating film. The polysilicon film 37 is made of polycrystal silicon and formed by film formation processing. It should be noted that the polysilicon film 37 is not doped with any dopant.

The anti-reflection film 38 is made of polymer resin including a pigment that absorbs light having a particular wavelength such as ArF excimer laser light irradiated toward the resist film 39. The anti-reflection film 38 prevents the ArF excimer laser light having passed through the resist film 39 from being reflected by the polysilicon film 37 to reach the resist film 39 again. The resist film 39 is formed by a positive type photosensitive resin and can be changed into alkali solubility by being irradiated with the ArF excimer laser light.

The anti-reflection film 38 is formed on the wafer W by, for example, being applied thereon. Thereafter the resist film 39 is formed using a spin coater (not shown). Furthermore, ArF excimer laser light is irradiated by a stepper (not shown) onto the resist film 39 in a pattern which is reversed into a predetermined pattern, whereby the part of the resist film 39 which is irradiated with the laser light is changed into alkali solubility. Then, strong alkali developing solution is dropped on the resist film 39, whereby the part having changed into alkali solubility is removed. As a result, the part of the resist film 39 corresponding to the pattern which is reversed into the predetermined pattern is removed, and therefore, the resist film 39 of the predetermined pattern remains on the wafer W. For example, there remains the resist film 39 formed with the opening 40 in a position adjacent to a gate electrode. It should be noted that the anti-reflection film 38 is also formed with the opening 40 by means of etching in which the resist film 39 is used as a mask.

Next, an etching method according to this embodiment will be described.

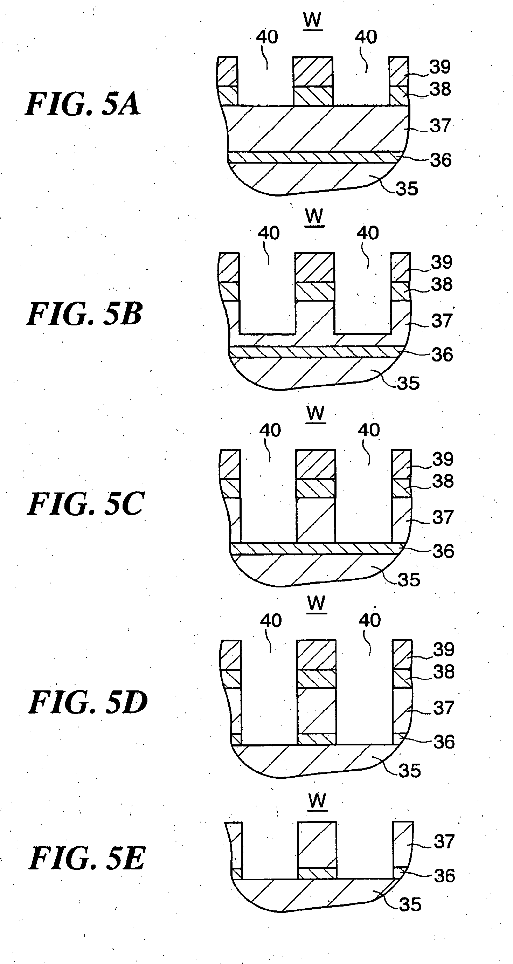

FIGS. 5A to 5E are a process diagram showing, as the etching method of this embodiment, an etching method for obtaining a semiconductor device gate structure.

First, a wafer W (FIG. 5A) is transferred into the processing vessel 11 of the substrate processing apparatus 10 and is attracted and held on an upper surface of the susceptor 12.

Next, the pressure in the processing spaces S1, S2 is set to 4.0 Pa (30 mTorr), and HBr gas, O₂ gas, and Ar gas are supplied from the processing gas supply unit 28 to the processing space S2 at predetermined flow rates. A microwave of 2.45 GHz is supplied to the radial line slot antenna 19, and high-frequency power of 400 KHz is supplied to the susceptor 12. At that time, HBr gas and the like are converted into plasma by being irradiated with the microwave radiated from the slot plate 20, whereby positive ions and radicals are produced. These positive ions and radicals collide and react with the part of the polysilicon film 37 which is exposed through the opening 40, thereby etching the exposed part of the film 37 (first etching step). The polysilicon film 37 is etched at its exposed part to the extent that the film 37 slightly remains on the gate oxide film 36 (FIG. 5B).

Next, the pressure in the processing spaces S1, S2 is set to 66.7 Pa (500 mTorr), and HBr gas and He gas are supplied to the processing space S2 at predetermined flow rates. While the microwave of 2.45 GHz is kept supplied to the radial line slot antenna 19, 60 watts of high-frequency power of 400 KHz is supplied to the susceptor 12. At that time, HBr gas and the like are converted into plasma by being irradiated with the microwave from the slot plate 20, and accordingly, positive ions and radicals are generated. These positive ions and radicals collide and react with the polysilicon film slightly remaining on the gate oxide film 36 (hereinafter referred to as the "residue polysilicon film"), whereby the residue polysilicon film is etched and completely removed (second etching step) (FIG. 5C). It should be noted that the residue polysilicon film is subjected to etching for 104 seconds.

When the residue polysilicon film is etched, the ambient pressure is set to a high pressure of 66.7 Pa. Under such a high pressure, the energy of plasma ions is lowered and hence the sputter ability of plasma is lowered. Besides the silicon oxide is less likely to be sputtered than the polysilicon. As a result, when the plasma has a low sputter ability, the etching speed of polysilicon (hereinafter referred to as the "etch rate") is only slightly lowered, but the etch rate of the silicon oxide is largely lowered. As a consequence, the selectivity of the polysilicon film 37 to the gate oxide film 36 can be increased without using oxygen plasma. To completely remove the polysilicon film 37, it is unnecessary to employ oxygen gas, thus making it possible to prevent oxidization of the part of the silicon base layer 35 which is located beneath the gate oxide film 36.

Next, the wafer W is transferred out from the processing vessel 11 of the substrate processing apparatus 10, and is then transferred into a processing vessel of a wet etching apparatus (not shown). Thereafter, that part of the gate oxide film 36 which has been exposed due to removal of the polysilicon film 37 is wet-etched using appropriate chemical or the like (third etching step). The exposed part of the gate oxide film 36 is etched until the silicon base layer 35 is exposed (FIG. 5D).

Next, the wafer W is transferred out from the processing vessel of the wet etching apparatus, and is then transferred into a processing vessel of an ashing apparatus (not shown). After the wafer W is transferred into the processing vessel of the ashing apparatus, O₂ gas and a high-frequency current are supplied to the processing vessel, whereby O₂ gas is converted into plasma, which removes the resist film 39 and the anti-reflection film 38. The resist film 39 and the anti-reflection film 38 are removed until the polysilicon film 37 is exposed (FIG. 5E), whereupon the present process is completed.

With the etching method of this embodiment, that part of polysilicon film 37 which is exposed through the opening 40 is etched to the extent that a part of the polysilicon film 37 on the side remote from the opening 40 remains unetched. Then under an ambient pressure of 66.7 Pa, the residue polysilicon film is etched using plasma generated from the processing gas consisting of HBr gas and He gas, i.e., the processing gas not containing oxygen gas. Since the sputter ability of plasma is lowered under a high pressure, the etch rate of the gate oxide film 36, which is less likely to be sputtered, greatly lowers, making it possible to increase the selectivity of the polysilicon film 37 to the gate oxide film 36. Since oxygen gas is not needed, the part of the silicon base layer 35 which is formed under the gate oxide film 36 will never be oxidized. In etching the gate oxide film 36, therefore, the just-mentioned part of the silicon base layer 35 can never be removed, resulting in suppression of recess formation.

In the above described etching method of this embodiment, when the polysilicon film 37 is etched so as to partly remain unetched, plasma generated from HBr gas and hence capable of efficiently etching the polysilicon film 37 is used. Then a mixture of HBr gas and He gas is used for etching the residue polysilicon film. Also at that time, plasma generated from the HBr gas is capable of efficiently etching the residue polysilicon film, thus improving throughput.

Although the residue polysilicon film is etched for 104 seconds in the etching method of this embodiment, the etching time is not limited thereto. From the viewpoint of improving throughput and suppressing the gate oxide film 36 from being etched, it is preferable that the etching time of the residue polysilicon film should be short and is particularly preferable between 10 seconds to 180 seconds.

In the etching method of this embodiment, 60 watts of high-frequency power is supplied to the susceptor 12 during the etching of the residue polysilicon film. However, the magnitude of the high-frequency power is not limited thereto but may be set according to the pressure in the processing spaces S1, S2. The lower the pressure in the processing spaces S1, S2, the stronger the sputter ability of plasma will be, and the lower the magnitude of the supplied high-frequency power, the weaker the sputter ability of plasma will be. From the viewpoint of suppressing the gate oxide film 36 from being etched, it is preferable that the magnitude of supplied high-frequency power be smaller at a lower pressure in the processing spaces S1, S2. Specifically, when the pressure in the processing spaces S1, S2 is at 13.3 Pa (100 mTorr), the supplied high-frequency power is preferably 30 watts.

In the etching method of this embodiment, the processing gas comprised of HBr gas and He gas is employed to etch the residue polysilicon film, but this is not limitative. For example, the processing gas may be one consisting of HBr gas alone. Instead of using He gas, another inactive gas such as rare gas (Ar gas) may be used.

In the etching method of this embodiment, a mixture of HBr gas and inactive gas is employed as the processing gas in etching the polysilicon film 37 so that part of the film 37 remains unetched, but this is not limitative. For example, instead of HBr gas, Cl₂ gas may be used.

In the etching method of this embodiment, the gate oxide film 36, the resist film 39, and the anti-reflection film 38 are etched in the processing vessel of the wet etching apparatus or the ashing apparatus. However, these films 36, 39 and 38 may be etched in the processing vessel 11 of the substrate processing apparatus 10.

In the etching method of this embodiment, the susceptor 12 is supplied with high-frequency power of 400 KHz in etching the residue polysilicon film. However, much higher high-frequency power may be supplied. More specifically, high-frequency power of 13.56 MHz may be supplied. Positive ions and the like in plasma cannot follow high-frequency voltage change. Thus, the sputter ability of plasma can be lowered by supplying high-frequency power of higher frequency to the susceptor 12.

It is to be understood that the present invention may also be accomplished by supplying a system or an apparatus with a storage medium in which a program code of software, which realizes the functions of the above described embodiment is stored, and causing a computer (or CPU or MPU) of the system or apparatus to read out and execute the program code stored in the storage medium.

In this case, the program code itself read from the storage medium realizes the functions of the above described embodiments, and therefore the program code and the storage medium in which the program code is stored constitute the present invention.

Examples of the storage medium for supplying the program code include a floppy (registered trademark) disk, a hard disk, a magnetic-optical disk, an optical disk such as a CD-ROM, a CD-R, a CD-RW, a DVD-ROM, a DVD-RAM, a DVD-RW, a DVD+RW, a magnetic tape, a nonvolatile memory card, and a ROM.

Further, it is to be understood that the functions of the above described embodiment may be accomplished not only by executing the program code read out by a computer, but also by causing an OS (operating system) or the like which operates on the computer to perform a part or all of the actual operations based on instructions of the program code.

Further, it is to be understood that the functions of the above described embodiment may be accomplished by writing a program code read out from the storage medium into a memory provided on an expansion board inserted into a computer or a memory provided in an expansion unit connected to the computer and then causing a CPU or the like provided in the expansion board or the expansion unit to perform a part or all of the actual operations based on instructions of the program code.

In the following, concrete examples of this invention will be described.

The present inventors examined influences of the pressure in the processing spaces S1, S2 and processing gas components (the presence or absence of O₂ gas) on recess formation.

[Example I] A wafer W shown in FIG. 4 was prepared and transferred into the processing vessel 11 of the substrate processing apparatus 10. HBr gas, O₂ gas, and Ar gas were supplied as the processing gas G1 into the processing space S2. The pressure in the processing spaces S1, S2 was set at 4.0 Pa, a microwave of 2.45 GHz was supplied to the radial line slot antenna 19, and high frequency power of 400 KHz was supplied to the susceptor 12, whereby the part of the polysilicon film 37 exposed through the opening 40 was etched to an extent that such film part slightly remained on the gate oxide film 36. Then HBr gas and He gas were supplied to the processing space S2, and the pressure in the processing spaces S1, S2 was set at 66.7 Pa. Using plasma generated from the HBr gas and the like, the residue polysilicon film was etched. It was confirmed that the residue polysilicon film was completely removed but the gate oxide film 36 was hardly etched.

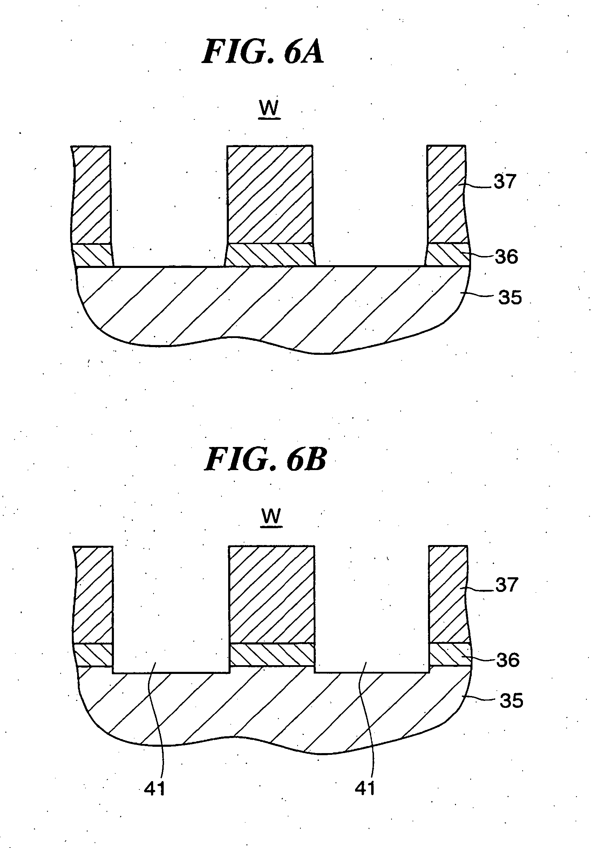

Then the wafer W was transferred into a processing vessel of a wet etching apparatus, and thereafter, the gate oxide film 36 exposed due to complete removal of the residue polysilicon film was etched. In succession, the anti-reflection film 38 and the resist film 39 were removed in an ashing apparatus. Subsequently, the gate formed on the wafer W was observed. As a result, it was confirmed that there were almost no recesses on the silicon base layer 35 (refer to FIG. 6A).

It was also confirmed that the gate oxide film 36 formed on the gate was formed into a shape somewhat widened toward an end thereof. It is considered that the reason why the shape of the gate oxide film 36 was widened toward its end is as follows: Since the pressure in the processing spaces S1, S2 was set at a relatively high pressure, the sputter ability of plasma was made weakened at the time of etching the polysilicon film 37, so that parts of the polysilicon film 37 corresponding to corners of the gate were not etched and were left, and these residue parts of the film 37 functioned as a mask when the gate oxide film 36 was etched.

Furthermore, it is considered that the reason why recess formation on the silicon base layer 35 could not be completely eliminated is that O₂ gas was discharged from oxide component parts of the processing vessel 11 during the etching of the residue polysilicon film and reached the silicon base layer 35 and that the knock-on phenomenon caused oxygen atoms in the gate oxide film 36 to reach the silicon base layer 35.

[Comparison Example 1] Under the same conditions as in the Example 1, the part of the polysilicon film 37 exposed through the opening 40 was etched so as to slightly remain on the gate oxide film 36. Then, the pressure in the processing spaces S1, S2 was set at 13.3 Pa, and HBr gas and 02 gas were supplied to the processing space S2, to thereby etch the residue polysilicon film by plasma generated from the HBr gas and the like. Then, the gate oxide film 36 exposed due to complete removal of the residue polysilicon film was removed. In succession, the anti-reflection film 38 and the resist film 39 were removed. Thereafter, the gate formed on the wafer W was observed and it was confirmed that there were recesses 41 of 5. 05 nm depth on the silicon base layer 35 (refer to FIG. 6B) and that the gate oxide film 36 in the gate was not formed into a shape widened toward its end.

From the above, it is understood that the selectivity of the polysilicon film 37 to the gate oxide film 36 can reliably be increased by setting the pressure in the processing spaces S1, S2 to a relatively high pressure such as 66.7 Pa at the time of etching the residue polysilicon film and that, as a result, the sputter ability of plasma is extremely weakened to extremely decrease the etch rate of the gate oxide film 36. It is also understood that recess formation on the silicon base layer 35 can be suppressed by etching the residue polysilicon film without using O₂ gas.

Next, the present inventors examined influences of the pressure in the processing spaces S1, S2 on ion implantation to the silicon base layer 35.

[Example 2] Under the same conditions as in Example 1, the part of the polysilicon film 37 exposed through the opening 40 was etched so as to slightly remain on the gate oxide film 36. Then, the residue polysilicon film was etched under the same conditions as in Example 1 except that the pressure in the processing spaces S1, S2 was set at 33.3 Pa.

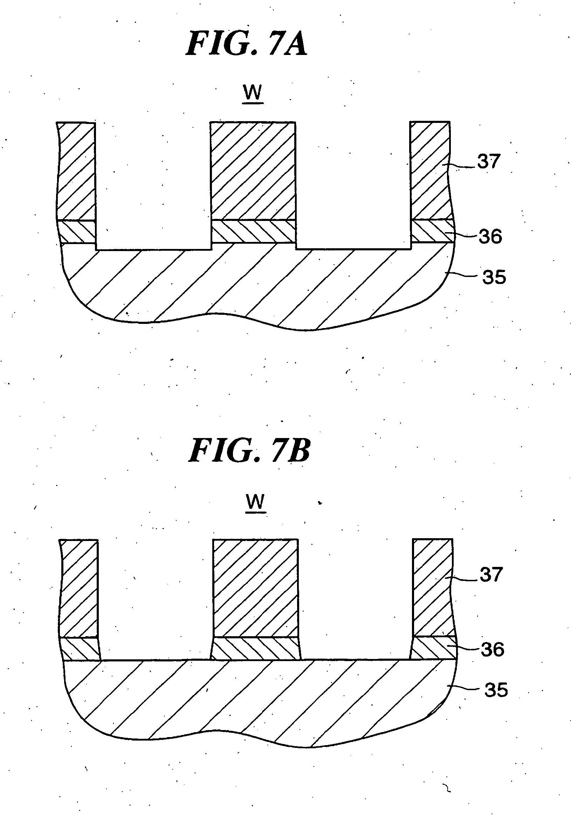

Then, the gate oxide film 36 exposed due to complete removal of the residue polysilicon film was removed, and then the anti-reflection film 38 and the resist film 39 were removed. Based on subsequent observations on the gate formed on the wafer W, it was confirmed that, although there were a few recesses on the silicon base layer 35, the depths of the recesses were less than a critical depth below which there is no affection to ion implantation to the silicon base layer 35 (refer to FIG. 7(A)). It was also confirmed that the gate oxide film 36 in the gate was not formed into a shape widened toward its end.

[Example 3] Under the same conditions as in Example 1, the part of the polysilicon film 37 exposed through the opening 40 was etched so as to slightly remain on the gate oxide film 36. Then, the residue polysilicon film was etched under the same conditions as in Example 1 except that the pressure in the processing spaces S1, S2 was set at 93.3 Pa (700 mTorr).

Then, the gate oxide film 36 exposed due to complete removal of the residue polysilicon film was removed. In succession, the anti-reflection film 38 and the resist film 39 were removed, and subsequently the gate formed on the wafer W was observed. As a result, it was confirmed that there were no recesses on the silicon base layer 35 and that the gate oxide film 36 in the gate was formed into a shape widened toward an end thereof, but the magnitude of being widened is less than a critical magnitude below which there is no affection to ion implantation to the silicon base layer 35 (FIG. 7B).

It should be noted that in Example 3, the pressure in the processing spaces S1, S2 was set at 93.3 Pa in etching the residue polysilicon film.

From the above, it is understood that the pressure in the processing spaces S1 and S2, at which ion implantation to the silicon base layer 35 is not affected, varies from 33.3 Pa to 93.3 Pa.

[Example 4] Under the same conditions as in Example 1 the part of the polysilicon film 37 exposed through the opening 40 was etched so as to slightly remain on the gate oxide film 36. The residue polysilicon film was etched under the same conditions as in Example 1 except that the pressure in the processing spaces S1, S2 was set at 40.0 Pa.

Then, the gate oxide film 36 exposed due to complete removal of the residue polysilicon film was etched. In succession, the anti-reflection film 38 and the resist film 39 were removed. Thereafter, the state of the gate oxide film 36 was observed, and it was confirmed that there were no cracks on the gate oxide film 36. It can be considered that at a pressure equal to or higher than 40.0 Pa, the sputter ability of plasma is extremely weakened and as a result, the selectivity of the polysilicon film 37 to the gate oxide film 36 can reliably be increased.

[Example 5] Several samples were prepared, in each of which the part of the polysilicon film 37 exposed through the opening 40 was etched so as to slightly remain on the gate oxide film 36 under the same conditions as in Example 1. Then, the pressure in the processing spaces S1, S2 was set to be different between the samples (specifically, the respective pressures were set to have several pressures varying around 80.0 Pa). Then, the residue polysilicon films of these samples were etched.

Subsequently, the gate oxide film 36 of the gate in each sample was observed. As a result, it was confirmed that a shape widened to an end of the gate oxide film becomes abruptly noticeable at a pressure beyond 80.0 Pa.

From Examples 4 and 5, it is understood that it is preferable that the pressure in the processing spaces S1, S2 be set in a rage from 40.0 Pa to 80.0 Pa.

## Claims

1. An etching method of a substrate having a silicon base layer on which at least a silicon oxide film, a polysilicon film, and a mask film having an opening are formed in sequence, comprising:
a first etching step of etching the polysilicon film using the mask film as a mask such that a part of the polysilicon film on a side remote from the opening remains on the silicon oxide film; and
a second etching step of etching the part of the polysilicon film remaining on the silicon oxide film using plasma generated from a processing gas containing hydrobromic gas but not containing oxygen gas,
**characterised in that** in said second etching step, the part of the polysilicon film remaining on the silicon oxide film is etched at an ambient pressure of 40.00 Pa to 80.00 Pa, and **in that** the ambient pressure of said first etching step is lower than that of said second etching step.

2. The etching method according to claim 1, wherein the processing gas containing hydrobromic gas but not containing oxygen gas is a mixture of the hydrobromic gas and inactive gas.

3. The etching method according to claim 1, wherein in said first etching step, the polysilicon film is etched by using plasma generated from hydrobromic gas, fluorocarbon gas, or chlorine gas.

4. The etching method according to claim 1, including:
a third etching step of etching the silicon oxide film.

5. Use of the etching method according to claim 1, for a fabrication of a semiconductor device.

## Patentansprüche

1. Ätzverfahren eines Substrats mit einer Siliziumbasisschicht, auf der wenigstens ein Siliziumoxidschicht, ein Polysiliziumfilm und ein Maskenfilm mit einer Öffnung in Folge ausgebildet sind, mit:
einem ersten Ätzschritt des Ätzens des Polysiliziumfilms unter Verwendung des Maskenfilms als eine Maske, sodass ein Teil des Polysiliziumfilms auf einer Seite von der Öffnung weg auf dem Siliziumoxidfilm verbleibt, und
einem zweiten Ätzschritt des Ätzens des Teils des Polysiliziumfilms, der auf dem Siliziumoxidfilm verbleibt, unter Verwendung von Plasma, das aus einem Prozessgas erzeugt wurde, das Bromwasserstoffgas enthält, jedoch kein Sauerstoffgas enthält,
**dadurch gekennzeichnet, dass** bei dem zweiten Ätzschritt der Teil des Polysiliziumfilms, der auf dem Siliziumoxidfilm verbleibt, bei einem Umgebungsdruck von 40,00 Pa bis 80,00 Pa geätzt wird und dass der Umgebungsdruck des ersten Ätzschritts niedriger ist als derjenige des zweiten Ätzschritts.

2. Ätzverfahren nach Anspruch 1, bei dem das Prozessgas, welches Bromwasserstoffgas enthält, jedoch kein Sauerstoffgas enthält, eine Mischung des Bromwasserstoffgases und eines inaktiven Gases ist.

3. Ätzverfahren nach Anspruch 1, bei dem bei dem ersten Ätzschritt der Polysiliziumfilm unter Verwendung von Plasma geätzt wird, das aus Bromwasserstoffgas, Fluorocarbongas oder Chlorgas erzeugt wurde.

4. Ätzverfahren nach Anspruch 1, mit:
einem dritten Ätzschritt des Ätzens des Siliziumoxidfilms.

5. Verwendung des Ätzverfahrens nach Anspruch 1 zum Herstellen einer Halbleitereinrichtung.

## Revendications

1. Procédé de gravure d'un substrat ayant une couche de base de silicium sur laquelle au moins un film d'oxyde de silicium, un film de polysilicium, et un film de masque ayant une ouverture sont formés dans l'ordre, comprenant :
une première étape de gravure qui consiste à graver le film de polysilicium en utilisant le film de masque en tant que masque de sorte qu'une partie du film de polysilicium sur un côté éloigné de l'ouverture reste sur le film d'oxyde de silicium ; et
une deuxième étape de gravure qui consiste à graver la partie du film de polysilicium restant sur le film d'oxyde de silicium en utilisant du plasma généré à partir d'un gaz de traitement contenant du gaz bromhydrique mais ne contenant pas de l'oxygène gazeux,
**caractérisé en ce que** dans ladite deuxième étape de gravure, la partie du film de polysilicium restant sur le film d'oxyde de silicium est gravée à une pression ambiante allant de 40,00 Pa à 80,00 Pa, et **en ce que** la pression ambiante de ladite première étape de gravure est inférieure à celle de ladite deuxième étape de gravure.

2. Procédé de gravure selon la revendication 1, dans lequel le gaz de traitement contenant du gaz bromhydrique mais ne contenant pas de l'oxygène gazeux est un mélange du gaz bromhydrique et d'un gaz inactif.

3. Procédé de gravure selon la revendication 1, dans lequel dans ladite première étape de gravure, le film de polysilicium est gravé en utilisant du plasma généré à partir d'un gaz bromhydrique, d'un gaz fluorocarboné, ou d'un gaz chlore.

4. Procédé de gravure selon la revendication 1, comportant : une troisième étape de gravure qui consiste à graver le film d'oxyde de silicium.

5. Utilisation du procédé de gravure selon la revendication 1, pour une fabrication d'un dispositif à semi-conducteur.
